**Europäisches Patentamt**

(19) **European Patent Office**

**Office européen des brevets**

(11) Numéro de publication: **0 188 148**
**B1**

(12) **FASCICULE DE BREVET EUROPÉEN**

(45) Date de publication du fascicule du brevet:
25.01.89

(51) Int. Cl.⁴: **H 01 L 21/70**

(21) Numéro de dépôt: **85402414.8**

(22) Date de dépôt: **04.12.85**

(54) Procédé de photolithographie d'une couche épaisse de pâte déposée sur un substrat.

(30) Priorité: **07.12.84 FR 8418776**

(43) Date de publication de la demande:
**23.07.86 Bulletin 86/30**

(45) Mention de la délivrance du brevet:
**25.01.89 Bulletin 89/4**

(84) Etats contractants désignés:
**DE GB NL SE**

(56) Documents cité:
**EP-A-0 016 231**
**DE-A-2 003 983**

**IEEE TRANSACTIONS ON COMPONENTS, HYBRIDS, AND MANUFACTURING TECHNOLOGY, vol. CHMT-2, no. 4, décembre 1979, pages 428-433, IEEE, New York, US; Y. WATANABE et al.: "Thick-film fine pattern formation by a photolithographic process"**

Le dossier contient des informations techniques présentées postérieurement au dépôt de la demande et ne figurant pas dans le présent fascicule.

(73) Titulaire: **THOMSON- CSF, 173, Boulevard Haussmann, F-75379 Paris Cédex 08 (FR)**

(72) Inventeur: **Dufour, Michel, THOMSON- CSF SCPI 173, bld Haussmann, F-75379 Paris Cedex 08 (FR)**

(74) Mandataire: **Taboureau, James, THOMSON- CSF SCPI 19, avenue de Messine, F-75008 Paris (FR)**

## Description

La présente invention concerne un procédé de photolithographie des couches épaisses déposées sur un substrat solide, de pâte utilisée dans l'industrie des circuits hybrides, afin de réaliser des réseaux de motifs très fins, et d'obtenir par des méthodes simples telle que la sérigraphie ou l'enduction à la raclette des motifs de dimensions latérales aussi fines que celles obtenues par des méthodes plus sophistiquées telle que l'évaporation sous vide, pour les couches minces.

Il existe deux méthodes pour réaliser les réseaux de motifs sur un substrat solide et électriquement isolant. L'une est la méthode des couches minces, qui utilise l'évaporation sous vide ou la pulvérisation cathodique d'un solide, métal ou alliage, dont la couche, épaisse de quelques nanomètres à quelques micromètres, est ensuite gravée chimiquement par un procédé bien connu de photolitographie. La précision obtenue, qui est celle des masques photographiques, est de l'ordre du micromètre une dimension du motif parallèle au plan du masque, mais cette méthode requiert un matériel de dépôt coûteux. L'autre est la méthode des couches épaisses selon laquelle une couche de pâte épaisse de 1 à 50 micromètres environ est soit étendue à la raclette soit déposée par sérigraphie. Le matériel d'enduction est moins coûteux que le matériel de dépôt de couches minces, mais la précision obtenue, ou plus exactement la finesse des motifs réalisés, est limitée par la dimension minimale des mailles de l'écran de sérigraphie, et est d'environ 200 micromètres (125 μm dans certains cas).

L'un des objectifs de l'invention est de réaliser des circuits hybrides, monocouches ou multicouches, dont au moins un réseau de motifs, en surface du circuit hybride, est en couche épaisse mais avec une finesse de dessin comprise entre 10 et 100 μm telle qu'elle permette de l'adapter aux composants microélectroniques les plus avancés. Par exemple les pastilles de circuits intégrés dits VLSI comportant jusque 200 - 300 sorties aux pas de 100 μm, ou les boîtiers de chip-carriers comportant jusqu'à 400 sorties périmètriques: à proximité de la pastille, et pour pouvoir la connecter sur le réseau extérieur, il est nécessaire que les motifs en couches épaisses aient des dimensions compatibles avec celles de la pastille.

Un autre objectif de l'invention est de permettre la réalisation de circuits, notamment hybrides, dont les pistes conductrices et resistives du réseau ont des longueurs et des espaces d'écartement entre elles que soient cohérentes avec la fréquence ou, ce qui revient au même, la longueur d'onde du système électronique en fonctionnement. En hyperfréquence notamment, il est connu que le circuit d'interconnexion doit être adapté, c'est-à-dire de dimensions d'autant plus petites que la fréquence augmente.

C'est encore un autre objectif de l'invention que de pouvoir réaliser des réseaux de motifs en utilisant des produits normalement disponibles dans le commerce, c'est-à-dire des pâtes conductrices, résistives ou diélectriques, pour les couches épaisses, et des résines de photorésists pour la photolithographie, positives ou négatives, ne nécessitant pas une préparation spéciale.

Selon l'invention une couche épaisse de pâte, constituée de particules solides et de liants organiques, est enduite sur un substrat rigide et généralement isolant tel qu'une céramique, alumine ou oxyde de béryllium, à la raclette ou par sérigraphie. Si la couche est sérigraphiée, elle comporte dans un premier temps un réseau de motifs dont les dimensions minimales sont imposées par celles des mailles de l'écran de sérigraphie. Cette couche est séchée puis recouverte d'une couche de photorésist, qui est masquée au moyen d'un masque reproduisant le réseau de motifs, mais avec une plus grande définition. Ceci signifie que si un motif sérigraphié a une largeur de 200 micromètres parce qu'il est difficile d'obtenir une meilleure définition par sérigraphie, le masque correspondant à ce motif a une précision qui est couramment de l'ordre de 1 μm, qui est aussi la précision des masques photographiques pour la technique des couches minces. L'exposition du photorésist à un rayonnement tel que les ultraviolets à travers ce masque permet de définir dans le motif en couches épaisses une zone qui sera conservée et qui est très bien définie, et une zone qui sera photogravée et supprimée. Le photorésist est alors développé et la couche épaisse gravée, aux endroits non protégés par la couche de photorésist, par une solution organique telle qu'elle présente une solubilité différentielle plus grande vis-à-vis de la pâte de la couche épaisse que vis-à-vis de la resine du photorésist. La gravure chimique est combinée à un balayage mécanique des particules solides de la pâte de la couche épaisse, car la solution organique de gravure est pulvérisée sous pression: le liant de la pâte étant dissous, les particules solides, conductrices ou résistives ou diélectriques n'adhèrent plus sur le substrat et sont éliminées. La solution organique de gravure selon l'invention a été mise au point pour que la couche épaisse de pâte soit totalement gravée et les particules solides totalement balayées avant que la couche de photorésist ne soit dissoute par la même solution organique de gravure.

De façon plus précise, l'invention concerne un procédé de photolithographie d'une couche épaisse de pâte déposée sur un substrat plan, la pâte étant composée de particules solides qui ont une fonction électrique (conductrice, résistive ou diélectrique) ou de protection mécanique et d'un liant organique, et étant séchée à 80 - 120°C, comportant les opérations suivantes:

- une couche de résine photosensible est déposée sur la couche épaisse puis est exposée à un rayonnement à travers un masque photographique à haute définition, et développée,

- les parties de la couche épaisse qui ne sont pas protégées par les motifs restants du masque de résine photosensible sont gravées au moyen d'un mélange de solvants organiques, ce mélange présentant une solubilité différentielle vis-à-vis du liant organique de la couche épaisse de pâte et vis-à-vis de la résine photosensible, la solubilité de la couche épaisse étant plus grande que la solubilité de la résine photosensible, et étant pulvérisé sous pression pour balayer totalement les particules solides du liant organique,

- la couche épaisse est cuite à 850°C, pour la fritter et éliminer le masque de résine photosensible.

L'invention sera mieux comprise par la description détaillée qui suit, laquelle s'appuie sur les figures jointes en annexe et qui représentent:

- figure 1: schéma synoptique d'un procédé de photogravure selon l'art connu;
- figures 2 à 4: schéma du procédé de photogravure selon l'invention, dans le cas d'une couche épaisse étendue à la raclette;
- figure 5 : schéma simplifié du procédé de photogravure selon l'invention dans le cas d'une couche épaisse sérigraphiée.

Un rappel préliminaire des produits mis en jeu dans les circuits hybrides à couches épaisses permettra de préciser les opérations qui seront décrites ultérieurement, et de mieux expliciter les phénomènes qui se passent au cours de ces opérations.

Les substrats sont généralement des plaques de matériaux isolants électriques et conducteurs thermiques, tels que l'alumine, l'oxyde de béryllium ou également les tôles émaillées. Si ces substrats sont en céramique, ils sont cuits de façon à leur communiquer la rigidité nécessaire aux opérations de réalisation d'un réseau de motifs.

Ce que l'on appelle les pâtes sont des mélanges de particules solides, (métalliques, céramiques), de liants et de solvants. La nature des particules solides, qui constituent l'essentiel d'une pâte, dépend de l'objectif recherché. Les pâtes conductrices sont à base de particules solides d'or, d'argent ou d'or platine par exemple ainsi que d'autres métaux moins rares et moins coûteux mais bons conducteurs électriques. Ces pâtes conductrices sont destinées à réaliser des pistes d'interconnexions conductrices. Les pâtes resistives sont à base de particules métalliques et céramiques telles que argent-palladium et oxyde de ruthénium, avec lesquelles sont réalisées des résistances. Enfin les pâtes dites diélectriques sont à base de particules d'oxyde de titane ou de zirconium, elles servent à la réalisation de zones capacitives, ou d'isolement entre deux pistes conductrices situées dans deux plans parallèles d'un circuit hybride. Enfin les pâtes protectrices sont à base de verre à bas point de fusion et assurent essentiellement une protection mécanique. Une poudre de verre ajouté aux particules solides sert de liant minéral c'est-à-dire que lorsque le circuit hybride aura été cuit à 850° pour fritter les particules solides, le verre qui a fondu maintiendra la cohésion entre elles des particules solides. Enfin les liants sont des resines qui permettent de donner au mélange de particules solides et de particules de verre une certaine fluidité de façon à pouvoir étaler les pâtes soit à la raclette soit par sérigraphie. Le rôle de ces resines est provisoire puisqu'elles disparaissent lors de la cuisson du circuit hybride. Les liants sont à base de méthylcellulose ou diéthylcellulose, dissoutes dans des solvants organiques tels que le butylcarbitol ou l'acétate de butylcarbitol, une telle composition de liants étant universellement adoptée pour les pâtes en couches épaisses.

Ces couches font entre 4 et 35 μm environ après séchage de ladite couche. Elles sont épaisses par rapport à celles que l'on nomme les couches minces, qui sont déposées par évaporation sous vide ou pulvérisation cathodique, et dont l'épaisseur est comprise entre 0,01 et 1 μm environ.

Il y a deux types de gravure pour les couches épaisses. La gravure en sec se dit d'une couche épaisse qui a été seulement sechée après enduction, à une température d'environ 150°C. C'est-à-dire que, à 150°C, seuls sont évaporés les solvants de la résine de liants, et la couche épaisse présente une consistance qui est encore plastique, puisque outre les particules solides et minérales, elle comporte encore une résine à base de cellulose. La gravure en cuit se dit d'une couche épaisse qui après enduction a été séchée puis cuite à 850°, ce qui assure le frittage des particules solides. A 850° le liant a été éliminé et la couche épaisse cuite ne présente plus que des composants minéraux, mais ne comporte plus de partie organique.

Les résines photosensibles, ou photorésists, utilisées pour la gravure des couches épaisses sont les mêmes que celles qui sont utilisées pour les gravures de couches minces. Elles sont de deux types: les résines positives pour lesquelles les parties exposées deviennent solubles dans le solvant considéré et les résines négatives, dont les parties soumises aux rayons ultraviolets deviennent insolubles dans certains solvants.

Les résines se présentent à l'état liquide, et parfois, pour les résines négatives, à l'état solide sous forme d'un film. Ce sont des solutions d'esters d'orthoquinone-diazides et de carboxy-méthylesters de phénolformaldéhyde prépolymérisé. Elles sont initialement solubles dans les solvants organiques et deviennent insolubles après exposition aux rayons ultraviolets. Ce changement de solubilité dépend uniquement de la décomposition photochimique de l'orthoquinone diazide, suivie par une transformation et une hydrolyse qui donne de l'acide carboxylique. Le maximum de sensibilité pour les résines photosensibles se situe entre 0,30 μm et 0,45 μm.

Les résines photosensibles sont en solution dans des produits tels que le buthylcellosolve, le xylène, le glycol.

Les photorésists sont déposées à la surface libre de la couche épaisse soit par centrifugation, soit par pulvérsation, soit par d'autres procédés tel que le trempé. Avant d'être exposés aux ultraviolets à travers un masque, les photorésists sont séchés par soufflage d'air chaud, en étuve ventilée par exemple, à une température qui varie entre 40 et 80°C suivant le produit.

Enfin par réseau de motif, on entend des réseaux de pistes conductrices, de zones résistives ou capacitives, ou encore de plots de soudure et de connexions. Il est nécessaire, pour s'adapter aux techniques d'intégration poussées du genre VLSI, que ces réseaux de motifs soient à très hautes définitions. Par finesse d'un réseau, il faut entendre la définition de ses dimensions dans un plan parallèle au plan de substrat: par exemple un motif est dit à 50 μm - 50 μm si la largeur du motif est de 50 μm et qu'un espace de garde avec le motif voisin est également de 50 μm. La finesse d'un réseau de motif définit ses dimensions dans un plan horizontal mais l'épaisseur de la couche épaisse n'entre pas en considération dans le cas présent.

La réalisation d'un réseau de motifs en couches épaisses de haute définition est un problème majeur actuellement pour l'adaptation de pastilles de VLSI à des circuits extérieurs, sans détériorer les qualités et caractéristiques du VLSI par un réseau d'interconnection qui ne soit pas adapté. L'objet de l'invention est donc d'obtenir des définitions de traits de 50 μm par un procédé de photolithographie en sec, c'est-à-dire que la pâte sérigraphiée est seulement séchée à environ 150°C. Cette filière technologique doit allier le faible coût de la sérigraphie aux définitions obtenues avec les couches minces, en ce qui concerne les conducteurs, les resistances et les isolants. Par conséquent le procédé selon l'invention consiste à graver et obtenir un motif défini par un masque photolithographique à partir des couches déposées par la méthode des couches épaisses, soit à la raclette, soit par sérigraphie.

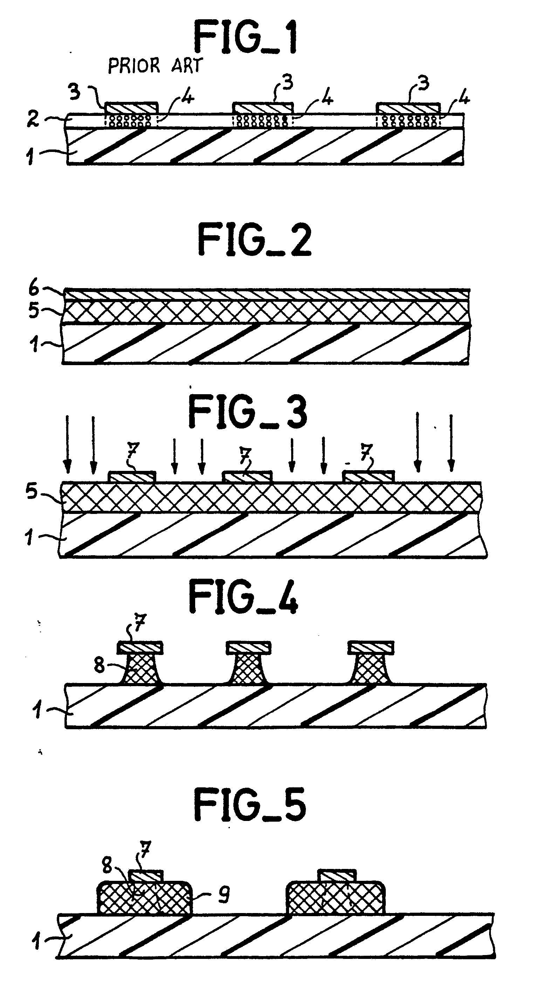

Une méthode pour former des réseaux fins de motifs er couches épaisses est décrite dans la demande du brevet européen 0 016 231 et illustrée par la figure 1.

Selon cette méthode, sur un substrat 1 est étendue une couche épaisse de pâte 2, puis un film de photorésist 3. Le photorésist est ensuite impressionné à travers un masque, ce qui donne les motifs dans l'état ou ils sont représentés sur la figure 1. La couche épaisse de pâte 2 est alors retirée par des moyens chimiques, ce qui donne un processus presque conventionnel par rapport à l'art connu.

Toute l'originalité de la méthode décrite dans le document cité réside en ce que l'une des deux couches, par exemple la couche de photorésist, est soluble dans l'eau, tandis que l'autre couche, par exemple la couche épaisse, est soluble dans des solvants organiques ce qui fait que la dissolution par un solvant organique de la couche épaisse non masquée n'entraîne pas la dissolution de la couche de photorésist, dans ces motifs 3. Lorsque la couche épaisse 2 a été gravée, et que l'on y a donc formé des motifs 4 dont la définition est aussi fine que celle des motifs 3 du photorésist, le circuit est alors cuit à des températures de l'ordre à 850°C ce qui durcit les motifs 4 et supprime les motifs de photorésist 3 qui sont éliminés au cours de cuisson.

Dans ce procédé, le film de photorésist 3 n'inclut pas d'agents organiques, et il est à base d'alcool polyvinylique. C'est un photorésist de type négatif qui a été mis au point spécialement par les inventeurs en vue de réaliser la photogravure de couches épaisses. Cependant un photorésist contenant des agents organiques peut être utilisé avec certaines pâtes à conditions que l'interaction entre le photorésist, le produit de développement et la couche épaisse soit négligeable. C'est donc un inconvénient de la méthode que de nécessiter dans la majorité des cas la préparation soit d'un photorésist spécial soluble à l'eau si la pâte est de type organique, soit la préparation d'une pâte spéciale soluble à l'eau si le photorésist est organique et comporte des solvants courants dans ce type d'activité.

C'est donc un objet de l'invention que d'avoir mis au point un procédé qui ne nécessite pas d'avoir recours à des photorésists ou à des pâtes spécialement préparées à cette fin.

Selon le procédé de l'invention, sur un substrat 1 est déposée une couche épaisse de pâte 5. L'épaisseur de cette couche est couramment comprise entre 4 et 15 μm, mais elle peut atteindre des épaisseurs allant jusqu'à 35 μm après séchage. La couche épaisse est effectivement séchée à une température variant entre 80° et 120°C, en étuve ventilée, la température étant choisie en fonction de la nature conductrice, résistive diélectrique ou isolante de la pâte et en fonction des solvants qui sont ajoutés à sa fabrication.

Sur la couche épaisse 5, dont la surface extérieure est plane et présente une dureté suffisante est déposée une couche de photorésist 6. Il est nécessaire que la surface de la couche épaisse 5 présente une dureté adéquate pour que les solvants introduits dans le mélange photorésist ne pénétrent pas dans la couche épaisse 5. L'épaisseur du dépôt de photorésist est de l'ordre de 0,5 à 2 μm, légèrement plus selon les encres utilisés pour la couche épaisse. Il n'est pas possible et pas utile de déposer une couche plus épaisse car lorsque le circuit hybride est cuit, tout à fait à la fin des opérations, le photorésist s'élimine, mais avant d'être évaporé à 850°C il se rétracte et entraîne un décollement de la couche épaisse, malgré des vitesses de montées en température lentes, de façon à ne pas exercer de force entre la couche de photorésist et la couche épaisse. Des mesures ont montré que le dépôt par centrifugation du photorésist, c'est-à-dire des dépôts d'épaisseur de l'ordre de 0,5 à 1 μm, n'entraînent pas de décollement de la couche épaisse.

L'operation suivante, illustrée en figure 3, consiste à exposer et développer le masque de photorésist. La couche 6 de photorésist est exposée à travers un masque approprié, par un rayonnement dont la longueur d'onde doit correspondre à la zone de sensibilité spectrale maximale du photorésist, c'est-à-dire 0,30 μm et 0,45 μm, au moyen d'une source d'exposition appropriée telle qu'une lampe à arc, à vapeur de mercure, à xénon pulsé ou un tube de lumière noire. Mais en outre, pour obtenir de hautes définitions, il est nécessaire d'avoir une source à rayons parallèles. Il faut également refroidir le châssis afin d'éviter une variation dimensionnelle du masque d'insolation, un bullage du photorésist ou un éventuel recuit pendant l'exposition.

Le développement du masque de photorésist, qui permet de ne conserver de la couche 6 que les motifs 7, peut se faire au trempé en bain mort, avec agitation des substrats, ou par pulvérisation de solvants, mais la pulvérisation donne de meilleurs résultats en ce qui concerne la définition des motifs réalisés. Le solvant est le solvant normal du photorésist, et est souvent livré par le fournisseur de photorésist. La température au cours du développement doit être maintenue constante dans une fourchette de quelques degrés, car elle a une grande influence sur la vitesse de développement. Le développement est suivi d'un rinçage abondant, pour retirer toutes les parties organiques provenant du photorésist, qui pourraient ensuite détériorer la finesse du réseau de motifs en couches minces.

Enfin le masque de photorésist est cuit: bien que cette opération ne soit pas indispensable, elle s'effectue à une température de l'ordre de la température de séchage, c'est-à-dire 80 à 120°C, et améliore la tenue de la résine face aux agents de gravure de la couche épaisse.

L'opération de photolithographie en sec à proprement parler est l'opération suivante. L'attaque chimique peut être effectuée en bain mort ou par pulvérisation à température ambiante ou en bain chaud, c'est-à-dire 30/40°C, mais la pulvérisation permet d'obtenir les meilleurs résultats.

Elle s'effectue directement aux endroits non protégés et est représentée symboliquement par des flèches sur la figure 3. L'attaque chimique peut être effectuée en simple face ou en double face si le circuit hybride est en double face. Elle s'effectue progressivement en formant une attaque latérale, c'est-à-dire un début de gravure sous la résine protectrice, et l'importance de cette attaque latérale varie selon la nature du matériau, la solution de gravure et les conditions de gravure. L'attaque latérale est généralement égale à la moitié de l'épaisseur à graver, mais il est possible de faire une compensation dans le dessin du masque d'insolation pour tenir compte de la valeur approximative de l'attaque latérale.

L'agent de gravure est un mélange de deux produits qui a été mis au point spécialement dans le cadre de l'invention, le mélange de ces deux produits étant plus facile à réaliser industriellement que la préparation soit d'un photorésist spécial, soit d'encre spéciale pour les couches épaisses. Ce mélange réunit le trichloroéthane fréquemment appelé chlorothème qui est un solvant qui attaque les liants organiques des encres. Mais ce solvant est trop agressif, et a une action trop rapide, c'est pourquoi il est additionné d'un produit qui joue le rôle de ralentisseur d'attaque et d'évaporation. En effet il est difficile de réaliser des opérations précises si l'attaque chimique de la couche épaisse se fait trop rapidement: il faut obtenir une latitude de l'ordre de 5 à 10 secondes sur le temps d'attaque, qui est lui-même de l'ordre de 10 secondes sans le retardateur. D'où la nécessité d'ajouter au trichloroéthane un retardateur pour atteindre un temps d'attaque qui soit compris entre 50 et 80 secondes.

Parmi les différents retardateurs essayés, le butylcarbitol ou éther monobutylique du diéthylène glycol, l'éther monobutylique de l'éthylène glycol et l'éther monobutylique de l'éthylène glycol acétate sont ceux qui ont donné les résultats les plus intéressants. L'acétate de butyle, le xylène et le terpinéol, mélangés au trichloroéthane, donnent également une solution de gravure de couches épaisses qui est efficace, mais les meilleurs résultats ont été obtenus avec un mélange comportant 70 % de trichloroéthane et 30 % de butyl carbitol. Les résultats sont jugés d'après la propreté de la pièce, c'est-à-dire l'élimination des particules solides résidus de la couche épaisse, d'après l'aspect de la couche épaisse, et d'après l'aspect de la gravure en sec et après cuisson. En effet une piece peut être proprement nettoyée, avoir une bonne définition de gravure en sec, et presenter après cuisson un aspect médiocre parce que l'encre de la couche épaisse est plus ou moins imprégnée du solvant, qui s'est échappé de la couche épaisse au cours de la cuisson.

La solution de gravure de la couche épaisse est pulvérisée sous une pression comprise entre 5 et 25 kg par $cm^2$ pour assurer un balayage mécanique des particules solides de l'encre de la couche épaisse. Le résultat est meilleur si la pulvérisation se fait sous un certain angle, voisin de 30° et à une température constante, de façon à ce que, au cours des diverses gravures d'un lot de fabrication, le temps de gravure reste lui aussi constant.

La pièce obtenue après gravure de la couche épaisse est représentée en coupe en figure 4. De la couche d'encre épaisse 5 déposée à l'origine il ne reste que des motifs fins 8, surmontés chacun par un masque de photorésist 7. L'opération suivante consiste alors à sécher pendant 15 minutes à 80°C en étuve ventilée le circuit hybride comportant un réseau de motifs fins mais qui sont toujours à l'état sec, c'est-à-dire que la couche épaisse comporte encore des parties organiques, dans ces motifs 8, et n'est pas encore cuite. La cuisson, qui donne donc un motif utilisable, dur, et sur lequel peuvent être rapportés ou soudés des composants a lieu à 850°C.

La figure 5 est un résumé d'une variante des figures 2 à 4 et représente le cas ou la couche épaisse 9 est déposée par sérigraphie de façon partielle sur le substrat. Il a été dit que par sérigraphie il est difficile d'obtenir des motifs dont les dimensions soient inférieures à 200 μm. En déposant un masque de photorésist sur un tel réseau sérigraphié puis en exposant le photorésist et en procédant à la gravure de la couche épaisse 9, on obtient des motifs 8, représentés en pointillés, ces motifs n'ayant plus que des dimensions minimales comprises entre 10 et 100 μm environ selon la nature de l'encre de la couche épaisse. Ainsi il est plus facile de réaliser des motifs fins avec une encre conductrice plutôt qu'avec une encre diélectrique ou de protection, les motifs de résistances étant d'une finesse intermédiaire. A titre d'exemple sont couramment réalisés des motifs conducteurs de 50 μm - espace 50 μm, des motifs résistants de 60 μm - espace 60 μm, et des motifs diélectriques ou de protection de 100 μm de côté.

Ces résultats montrent que la photogravure en sec permet la réalisation de réseaux conducteurs ou résistifs, sur un substrat de grandes dimensions, avec une résolution supérieure à la résolution atteinte par le procédé de sérigraphie. La précision des motifs obtenus est égale à la précision des masques pour le photomasquage de la résine photosensible cette technique de gravure s'applique soit à des substrats monocouches, soit à des substrats multicouches; dans ce cas, au moins le réseau constituant la couche supérieure est gravé avec une haute définition selon le procédé de l'invention, tandis que, si cela est nécessaire ou possible, les niveaux intermédiaires du multicouches sont simplement sérigraphiés. Le procédé de photogravure de couches épaisses selon l'invention, qui a l'avantage de ne nécessiter que la préparation d'un mélange de solvants organiques jouant sur la solubilité différentielle des deux couches de photorésist et d'encre en couche épaisse permet donc d'obtenir une largeur minimale des réseaux de conducteurs et de résistances, avec une densité maximale de lignes par millimètre pour les conducteurs et les résistances. La précision de la gravure et le profil des lignes gravées permettent de donner des dimensions minimales aux trous de liaisons dans les couches isolantes, dans le cas des circuits multicouches. Le procédé étant simple à mettre en oeuvre, et ne necessitant que des produits facilement disponibles dans le commerce, avec un bon rendement qui le rend industriel.

Il est essentiellement utilisé pour la réalisation de circuits hybrides monocouches et multicouches destinés à recevoir des systèmes électroniques fortement intégrés, du type des circuits integrés VLSI.

## Revendications

1. Procédé de photolithographie d'une couche épaisse de pâte déposée sur un substrat plan (1), la pâte étant composée de particules solides qui ont une fonction électrique (conductrice, résistive, diélectrique) ou de protection mécanique, et d'un liant organique, et étant séchée à 80 - 120°C comportant les opérations suivantes:
- une couche de résine photosensible (6) est déposée sur la couche épaisse (5) puis est exposee a un rayonnement U.V. à travers un masque photographique à haute définition, et développée,
   - les parties de la couche épaisse (5) qui ne sont pas protégées par les motifs restants (7) du masque de résine photosensible (6) sont gravées au moyen d'un mélange de deux solvants organiques, ce mélange présentant une solubilité différentielle vis-à-vis du liant organique de la couche épaisse de pâte et vis-à-vis de la résine photosensible, la solubilité de la couche épaisse étant plus grande que la solubilité de la résine photosensible, et étant pulvérisé sous pression pour balayer totalement les particules solides après dissolution du liant organique,
   - la couche épaisse est cuite à 850°C pour la fritter et éliminer le masque de résine photosensible.

2. Procédé de photolithographie d'une couche épaisse selon la revendication 1, caractérisé en ce que la dissolution chimique du liant organique de la couche épaisse est accompagnée d'un balayage mecanique des particules solides, le mélange de solvants étant pulvérisé sur la couche épaisse sous une pression comprise entre 5 et 25 Kg/cm$^2$ et sous un angle compris entre 0 et 30° par rapport au plan du substrat (1).

3. Procédé de photolithographie d'une couche épaisse selon la revendication 1, caractérisé en ce que le mélange de solvants comprend un solvant agressif vis-à-vis du liant organique de la couche épaisse de pâte et un solvant retardateur, qui permet de régler la durée de l'opération de gravure de la couche épaisse.

4. Procédé de photolithographie d'une couche épaisse selon la revendication 3, caractérisé en ce que le solvant agressif est le 111 trichloréthane.

5. Procédé de photolithographie d'une couche épaisse selon la revendication 3, caractérisé en ce que le solvant retardateur est choisi parmi: éther monobutylique de diéthylène glycol, éther monobutylique d'éthylène glycol, éther monobutylique d'éthylène glycol acétate, butyl acétate, xylène, terpinéol.

6. Procédé de photolithographie d'une couche épaisse selon la revendication 3, caractérisé en ce que le mélange de solvants comporte 70 % en volume de trichloréthane et 30 % en volume d'éther monobutylique de diéthylène glycol.

7. Procédé de photolithographie d'une couche épaisse selon la revendication 1, caractérisé en ce que la couche épaisse de pâte (5) est déposée sur le substrat (1) à la raclette, en couche continue, avec une épaisseur comprise entre 5 et 35 micromètres (après séchage).

8. Procédé de photolithographie d'une couche épaisse selon la revendication 1, caractérisé en ce que la couche épaisse de pâte (5) est déposée sur le substrat (1) par sérigraphie partielle ou totale en motifs (9) de dimensions minimales de l'ordre de 200 micromètres, avec une épaisseur comprise entre 5 et 35 micromètres (après séchage).

9. Procédé de photolithographie d'une couche épaisse selon la revendication 1, caractérisé en ce que les motifs (7) du masque de résine photosensible ont des dimensions minimales de l'ordre de:

- 50 µm, - espace 50 µm, pour les couches conductrices,

- 60 µm, - espace 60 µm, pour les couches résistives,

- 100 µm, - espace 100 µm, pour les couches diélectriques et de protection mécanique (verre isolant).

- 100 µm - de côté pour les fenêtres assurant la liaison après remplissage d'encre conductrice entre deux niveaux conducteurs situés dans deux plans parallèles et séparés d'environ 40 µm diélectrique.

**Patentansprüche**

1. Photolithographieverfahren für einen Dickfilm einer auf ein ebenes Substrat (1) aufgebrachten Paste, die aus eine elektrische Funktion (Leitfähigkeit, Widerstand, Dielektrikum) oder eine mechanische Schutzfunktion erfüllenden Feststoffpartikeln und einem organischen Bindemittel zusammengesetzt ist und bei 80 bis 120°C getrocknet wird, wobei das Verfahren nacheinander folgende Verfahrensschritte aufweist:

- eine Schicht aus lichtempfindlichem Harz (6) wird auf den dicken Pastenfilm (5) aufgebracht, dann einer UV-Strahlung durch eine Photomaske hoher Auflösung ausgesetzt und schließlich entwickelt,

- die Bereiche des Dickfilms (5), die nicht von den verbleibenden Motiven (7) der lichtempfindlichen Harzmaske (6) geschützt sind, werden mithilfe einer Mischung zweier organischer Lösungsmittel ausgeätzt, wobei diese Mischung eine unterschiedliche Lösbarkeit gegenüber dem organischen Bindemittel des dicken Pastenfilms und gegenüber dem lichtempfindlichen Harz besitzt, derart, daß die Lösbarkeit des Dickfilm größer als die Lösbarkeit des lichtempfindlichen Harzes ist, wobei die Mischung unter Druck aufgesprüht wird, um die Feststoffpartikel nach der Auflösung des organischen Bindemittels ganz zu überstreichen,

- der Dickfilm wird einer Wärmebehandlung bei 850°C ausgesetzt, um die Maske aus lichtempfindlichem Harz zu sintern und zu beseitigen.

2. Photolithographieverfahren für einen Dickfilm nach Anspruch 1, dadurch gekennzeichnet, daß die chemische Auflösung des organischen Bindemittels des Dickfilms von einem mechanischen Überstreichen der Feststoffpartikel begleitet ist, wobei die Mischung von Lösungsmitteln auf den Dickfilm unter einem Druck, der zwischen 5 und 25 kg/cm$^2$ liegt, und unter einem Winkel zwischen 0 und 30° bezüglich der Ebene des Substrats (1) aufgesprüht wird.

3. Photolithographieverfahren für einen Dickfilm nach Anspruch 1, dadurch gekennzeichnet, daß die Mischung von Lösungsmitteln ein aggressives Lösungsmittel gegenüber dem organischen Bindemittel der Paste des Dickfilms und ein verzögernd wirkendes Lösungsmittel enthält, das die Dauer der Ätzoperation des Dickfilms einzustellen erlaubt.

4. Photolithographieverfahren für einen Dickfilm nach Anspruch 3, dadurch gekennzeichnet, daß als aggressives Lösungsmittel 111-Trichloräthan verwendet wird.

5. Photolithographieverfahren für einen Dickfilm nach Anspruch 3, dadurch gekennzeichnet, daß das Lösungsmittel mit Verzögerungseffekt aus folgender Gruppe ausgewählt wird: Monobutyläther-Diäthylenglycol, Monobutyläther-Äthylenglycol, Monobutyläther-Äthylenglycolacetat, Butylacetat, Xylol, Terpineol.

6. Photolithographieverfahren für einen Dickfilm nach Anspruch 3, dadurch gekennzeichnet, daß die Mischung von Lösungsmitteln 70 Volumenprozent Trichlorathan und 30 Volumenprozent Monobuyläther-Diäthylenglycol enthält.

7. Photolithographieverfahren für einen Dickfilm nach Anspruch 1, dadurch gekennzeichnet, daß die Dickfilmpaste (5) auf das Substrat (1) mit einem Spachtel in durchgehender Schicht aufgebracht wird, und zwar in einer Dicke zwischen 5 und 35 µm (nach dem Trocknen).

8. Photolithographieverfahren für einen Dickfilm nach Anspruch 1, dadurch gekennzeichnet, daß die Dickfilmpaste (5) auf das Substrat (1) mit einer partiellen oder totalen Seriegraphietechnik in Form von Motiven (9) aufgebracht wird, deren Mindestabmessungen etwa 200 µm und deren Dicke zwischen 5 und 35 µm (nach dem Trocknen) betragen.

9. Photolithographieverfahren für einen Dickfilm nach Anspruch 1, dadurch gekennzeichnet, daß die Motive (7) der Maske aus lichtempfindlichem Harz etwa folgende Mindestabmessungen besitzen:

- 50 µm - Abstand 50 µm für die leitenden Schichten

- 60 µm - Abstand 60 µm für die Widerstandsschichten

- 100 µm - Abstand 100 µm für die dielektrischen Schichten und die mechanischen Schutzschichten (isolierendes Glas),

- 100 µm Seitenlänge für die Fenster, die nach dem Auffüllen mit leitender Tinte die Verbindung zwischen zwei in zwei parallelen Ebenen liegenden und von etwa 40 µm Dielektrikum getrennten leitenden Ebenen sicherstellen.

**Claims**

1. A photolithographic process for a thick film paste deposited on a plane substrate (1), the paste being composed of solid particles having an electric function (conductor, resistor, dielectric) or a mechanical protection function, and an organic binder, the paste being dried between 80 and 120° C, the process including the following steps:
   - a layer of photosensitive resin (6) is deposited on the thick film (5) and is then exposed to an ultraviolet radiation through a high definition photographic mask and finally developped,
   - the zones of the thick film (5) which are not protected by the remaining motives (7) of the photosensitive resin mask (6) are engraved by means of a mixture of two organic solvents, this mixture having a differential solubility with respect to the organic binder of the thick film paste and with respect to the photosensitive resin, the solubility of the thick film being higher than the solubility of the photosensitive resin, the mixture being pulverized under pressure in order to totally scan the solid particles after dissolution of the organic binder,
   - the thick film is heated to 850° C in order to sinter it and to eliminate the photosensitive resin mask.

2. A photolithographic process for a thick film according to claim 1, characterized in that the chemical dissolution of the organic binder of the thick film is accompanied by a mechanical scanning of the solid particles, the mixture of solvents being pulverized onto the thick film under a pressure situated between 5 and 25 kg/cm$^2$ and under an angle included between 0 and 30° with respect to the substrate (1) plane.

3. A photolithographic process for a thick film according to claim 1, characterized in that the mixture of solvents includes an aggressive solvent with respect to the organic binder of the thick film paste and a slowing down solvent which enables the duration of the thick film engraving operation to be adjusted.

4. A photolithographic process for a thick film according to claim 3, characterized in that the aggressive solvent is 111-trichlorethane.

5. A photolithographic process for a thick film according to claim 3, characterized in that the slowing down solvent is selected from among monobutylether of diethyleneglycol, monobutylether of ethyleneglycol, monobutylether of ethyleneglycolacetate, butylacetate, xylol, terpineol.

6. A photolithographic process for a thick film according to claim 3, characterized in that the mixtures of solvents comprises 70 vol.% of trichlorethane and 30 vol.% of monobutylether of diethyleneglycol.

7. A photolithographic process for a thick film according to claim 1, characterized in that the thick film paste (5) is deposited on the substrate (1) by means of a spatula and in a continuous layer having a thickness between 5 and 35 µm (after drying).

8. A photolithographic process for a thick film according to claim 1, characterized in that the thick film paste (5) is deposited on the substrate (1) by a partial or total serigraphic method, the patterns (9) having a minimum size of about 200 µm and a thickness of between 5 and 35 µm (after drying).

9. A photolithographic process for a thick film according to claim 1, characterized in that the patterns (7) of the photosensitive resin mask have approximately the following minimum dimensions:
   - 50 µm - interspace 50 µm for conductor films
   - 60 µm - interspace 60 µm for resistor films
   - 100 µm - interspace 100 µm for the dielectric films and for the mechanical protection films (insulating glass),
   - 100 µm for the side lengths of the windows which, after having been filled with conducting ink, ensure the connection between two conducting levels situated in two parallel planes and separated by a dielectric film of about 40 µm thickness.

# FIG_1

PRIOR ART

# FIG_2

# FIG_3

# FIG_4

# FIG_5